Europäisches Patentamt

European Patent Office

Office européen des brevets

(11) Publication number: **0 218 408**
A2

# EUROPEAN PATENT APPLICATION

(21) Application number: 86307280.7

(22) Date of filing: 22.09.86

(51) Int. Cl.⁴: **H 01 L 21/00,** H 01 L 21/28, H 01 L 29/08

(30) Priority: 25.09.85 US 779919

(43) Date of publication of application: 15.04.87
Bulletin 87/16

(84) Designated Contracting States: **DE FR GB**

(71) Applicant: **Hewlett-Packard Company, Mail Stop 20 B-O 3000 Hanover Street, Palo Alto California 94304 (US)**

(72) Inventor: **Chiu, Kuang Yi, 609 Arastradero, Palo Alto California 94306 (US)**
Inventor: **Hsu, Fu Chieh, 22393 Riverside Drive, Cupertino California 95014 (US)**

(74) Representative: **Williams, John Francis et al, J.F. Williams & Co 34 Tavistock Street, London WC2E 7PB (GB)**

(54) **Process for forming lightly-doped-grain (LDD) structure in integrated circuits.**

(57) A new lightly doped drain (LDD) process which does not require extra masking steps as compared to the conventional CMOS process employs a two layer side wall spacer technology, in which the LDD ion implantation for n-channel and p-channel devices can be carried out by sharing the $n^+$ or $p^+$ source and drain ion implantation mask. This provides maximum flexibility in designing optimum n- and p-channel LDD MOSFETs without using any additional mask steps other than the conventional CMOS mask levels, and is also compatible with self-aligned silicide process.

## Process for forming lightly-doped-drain (LDD) Structure in integrated circuits

This invention relates to a process for forming a lightly-doped-drain in integrated circuit technology.

By increasing the packing density, VLSI circuits have been scaled down considerably. Unfortunately, the smaller dimensions of the devices are associated with numerous physical phenomena and effects which interfere with the design and operation of these devices. One such phenomenon, hot-electron effects, is caused by the ever-increasing channel electric fields in scaled-down devices. The resulting excessive hot-electron substrate current can cause several problems. Most notable are overloading the on-chip substrate-bias generator, variations in threshold voltages, snap-back (avalanche) breakdown in a MOSFET transistor, or latch-up in CMOS circuits. Furthermore, the minority current in the substrate, which is generated by injection from the source substrate junction or by photons emitted from the high electric fields in the drain region of the transistor, can cause DRAM (dynamic random access memory) refresh-time degradation and can discharge other charge-storage or low-current carrying nodes. The threshold shift and transconductance degradation due to interface-state generation by high-energy electrons limits the maximum allowable operating bias and is a major reliability concern.

To relieve these hot-electron induced problems, many graded-drain structures such as offset-gate, double-diffused drain, and lightly-doped-drain (LDD) have been proposed. These structures lower the channel electric field in the device by providing a section of the drain and source with lower density doping. This lower density doping section drops part of the applied
voltage and thereby lowers the intensity of the
electric field. Unfortunately, the offset-gate
structure and the double-diffused drain are not
suitable for sub-micron channel-length devices. The
lightly-doped-drain (LDD) structure is suitable for
sub-micron channel-length devices. However, one or two
additional masking steps are required to manufacture
such a device in CMOS circuits. If the circuit
contains only n-type or only p-type LDD devices, one
extra masking step beyond that normally needed to
manufacture a VLSI device is required to form the LDD
structure. However, if the circuit contains both n-
type and p-type LDD devices, then two extra masking
steps beyond that normally needed to manufacture a CMOS
VLSI circuit is required. This is costly.

This invention presents a new way to achieve the LDD
structure in CMOS circuits without using extra masking
steps. This new process uses multiple layer side wall
spacers similar to those described in a pending patent
application entitled Side Wall Masked Isolation For
Semiconductor Fabrication, Serial Number 679,618,
incorporated herein by reference. The present invention
has a new and completely unanticipated use of side wall
spacers. Also, a new process for forming the side wall
spacers and the lightly doped regions is presented. In
the above-referenced patent application, a method is
disclosed which uses sidewalls in manufacturing an
oxide layer to avoid the formation of the so-called
"bird's beak" structure and a few other process- or
structure-induced defects. The walls and part of the
bottom of a channel are covered with a thin silicon
nitride ($Si_3N_4$) layer. An oxide is grown in the
channels which pushes the thin silicon nitride layer
out of the channel and produces smooth walls without the bird's beak structure and other malformations. The
thin nitride layer is then removed. The present
invention uses side walls to shield regions of the
source and drain adjacent to the gate from ion
implantation when the source and drain are heavily
doped. After these heavily-doped source and drain
regions are formed, the side wall spacers are removed
with a wet etching process and the newly exposed areas
immediately adjacent to the gate are lightly doped. In
this manner, a source and a drain with two regions of
differing concentrations of doping are formed.

Figures 1A - G illustrate the steps in the maskless
lightly-doped-drain process in accordance with the
invention.

Figures 2A - B illustrate the effect the first and
second layers have on the width of the gate-to-source
or gate-to-drain overlap.

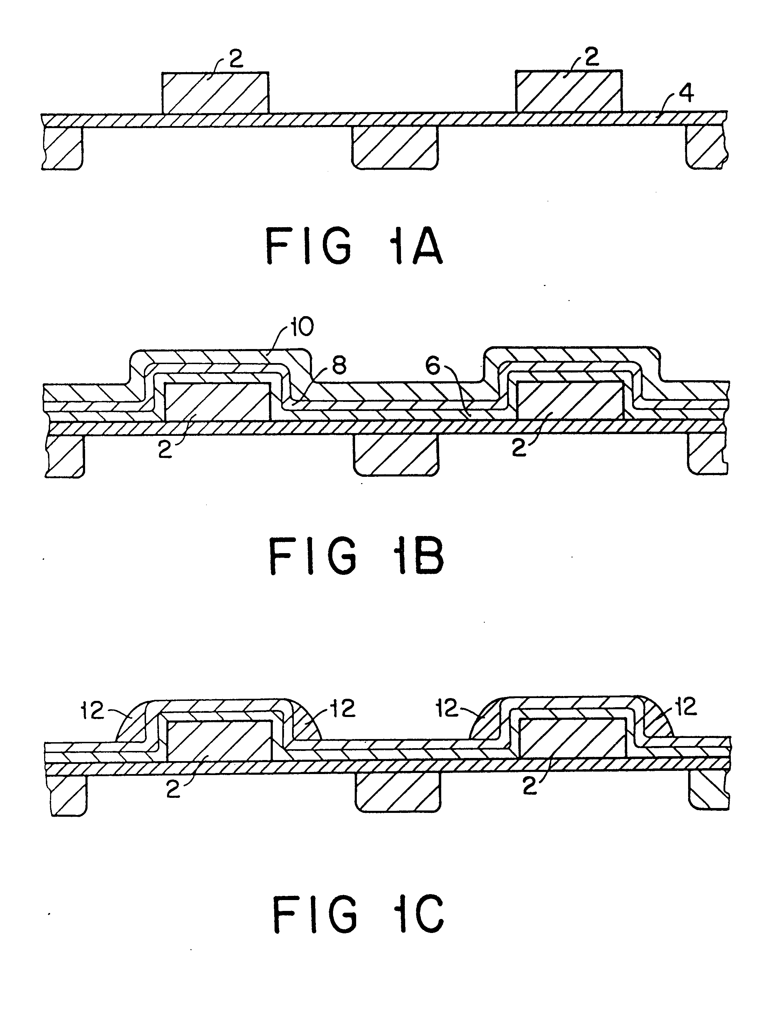

Figures 1A - 1G show the steps for manufacturing
lightly doped regions in the drain and source of a
transistor in accordance with the preferred embodiment
of the invention. Poly-silicon gates 2 are formed on a
single crystal silicon substrate 4 as shown in Figure
1A. Two or three layers of thin film 6, 8, 10 are
deposited (or grown) on the substrate 4 and gates 2 as
shown in Figure 1B. Each layer is capable of being an
etch-stop for the next layer. The first layer 6 is
optional; this layer 6 is a protective layer and, in
the preferred embodiment, is a layer of silicon dioxide
($SiO_2$) which is either grown at $900^\circ$ C in dry ambient
or chemically vapour deposited at low pressure with a
thickness of about 10 nm. The second layer 8 is
usually a low pressure chemically vapour deposited
(LPCVD) silicon nitride ($Si_3N_4$) with a thickness of about 25 nm. The third layer 10 is typically a layer of LPCVD-poly-silicon of a proper thickness. In the preferred embodiment, this thickness is between 220 nm and 150 nm. This layer 10 forms the outer portion of the side wall spacer 12 shown in Figure 1C.

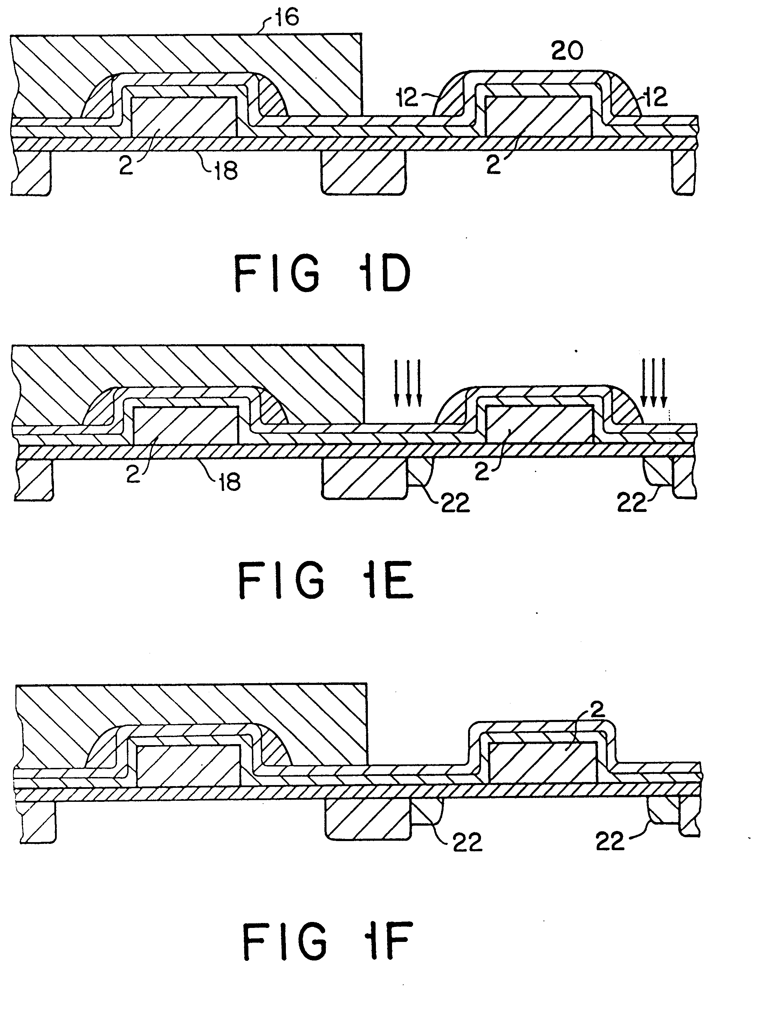

An anisotropic dry plasma etching process is used to remove most of the third layer 10. The silicon nitride second layer 8 acts as an etch-stop with etching process. In the plasma etching process, the portions along the sides of the gates 2 remain to form side walls 12. An ion implantation mask 16 is formed next. This mask 16 may be a conventional photoresist, such as Shipley #1470, available from Shipley Company, Inc. of Newton, Massachusetts, 02162. As shown in Figure 1D, the mask 16 is formed over devices 18 of one polarity, either n-channel or p-channel devices, while devices 20 of the opposite polarity, correspondingly either p-channel or n-channel devices, are ready for source and drain ion implantation.

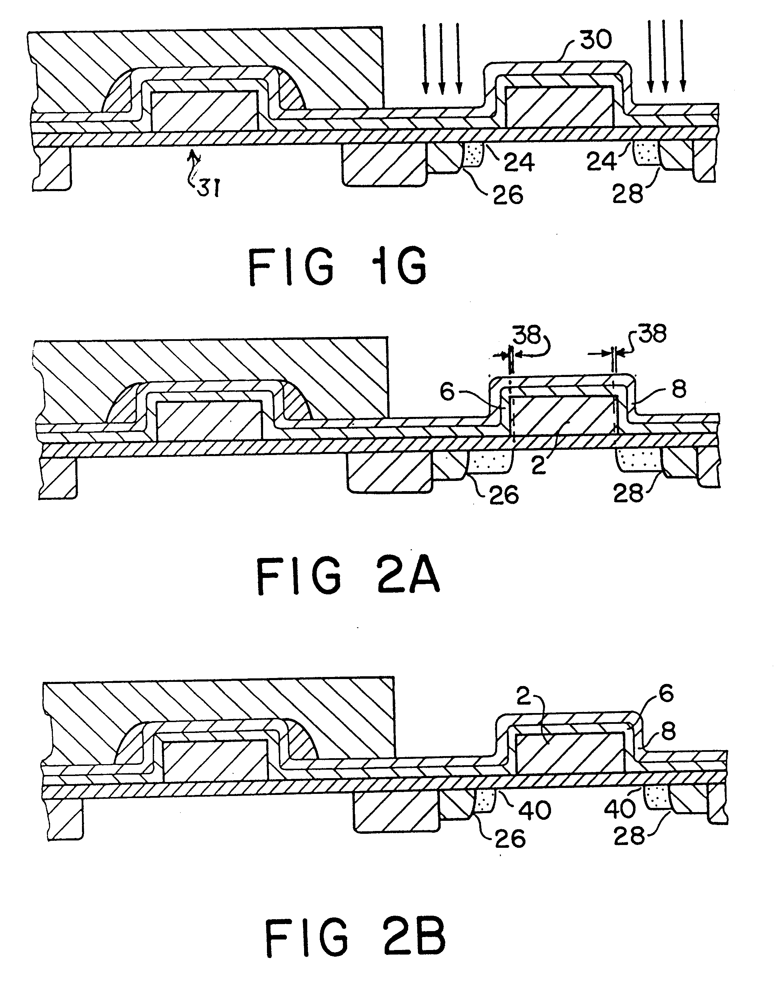

Next, heavily doped source and drain regions 22, as shown in Figure 1E, are formed, using a standard ion implantation technique using, for example, arsenic or phosphorous for an n-channel device and boron for a p-channel device. In the preferred embodiment, the concentration of ions is approximately 2 to 7 x $10^{15}$ /cm $^2$. During the ion implantation, the side walls 12 block the ions from penetrating the region beneath them. Next, the poly-silicon portion of the side walls 12 are stripped off with, for example, a wet chemical etching technique or an isotropic dry etching technique to expose areas which are to be less heavily doped. The resultant structure is shown in Figure 1F. An ion implantation technique, such as that described above, is applied to form a less heavily doped region 24 as shown in Figure 1G. In the preferred embodiment, the concentration of ions in this less heavily doped region 24 is approximately .5 to 2 x 10 $^{13}$ /cm$^2$. These regions of lesser dopant form part of the source 26 and the drain 28 of the transistor 30.

After this procedure is completed and the transistor 30 is formed, the photoresist mask 16 is stripped off. This method can then be repeated on the other device 31 of opposite polarity.

The total thickness of the optional first layer 6 and the second layer 8 is adjusted to obtain the proper gate 2 to source 26 and gate 2 to drain 28 overlap 38, 40 shown in Figures 2A and 2B. In Figure 2A, the first layer 6 and second layer 8 are made narrow to produce a gate-to-source or gate-to-drain overlap 38. In Figure 2B, the first layer 6 and second layer 8 are made thick to produce no gate-to-source or gate-to-drain overlap 40. The amount of source and drain overlap with the gate has a direct impact on effective channel length control and the short-channels effects.

The process described above is fully compatible with the self-aligned silicide process of the prior art. After both n- and p-channel devices are formed, the nitride etch-stop layer can be removed and a new oxide side wall spacer be formed to prevent gate-to-source or gate-to-drain shorts before the silicide is formed. In this self-aligned silicide process, the final spacer thickness will be non-critical since its dimension will not affect device characteristics.

0218408

## Claims

1.  A method for producing a lightly doped area in a substrate comprising the steps of:

(a)  forming a gate on a substrate;

(b)  covering the gate and the substrate with a first layer;

(c)  covering the first layer with a second layer;

(d)  removing the second layer but retaining side walls on the gate;

(e)  doping a first area of the substrate not shielded by the second layer;

(f)  removing the side walls; and

(g)  doping a second area of the substrate underneath the removed side walls to produce the lightly doped area.

2.  A method for manufacturing junctions as in claim 1, further comprising the step of forming a protective layer directly on the substrate and gates before the first layer is formed.

3.  A method for manufacturing junctions as in claim 1, wherein the step for covering the gates and the substrate include using silicon nitride to comprise the layer.

4.    A method for manufacturing junctions as in claim 1, wherein the step for covering the first layer with a second layer includes using silicon dioxide to comprise the second layer.

5.    A method for manufacturing junctions as in claim 1, wherein the step for removing the second layer includes using the first layer as an etch-stop.

6.    A method for manufacturing junctions as in claim 1, wherein the step for removing the second layer includes using an anisotropic etching process.

7.    A method for manufacturing junctions as in claim 1, wherein the step for selectively covering includes using photoresist and developing the photoresist.

8.    A method for manufacturing junctions as in claim 1, wherein the step for removing the side walls includes a standard wet etching process.

9.    A method for manufacturing junctions as in claim 1, wherein the step for forming a second doped area further comprises forming a doped area having a smaller concentration of ions than the first doped area.

10.    A method for manufacturing junctions as in claim 1, further comprising the step of adjusting the depth of the first layer to vary the overlap of the gate with the source and drain.

11.  A method for manufacturing junctions as in claim 1, further comprising the step of selectively covering regions of the substrate with a mask.

12.  An integrated circuit device having a lightly doped drain manufactured by the method of any preceding claim.

FIG 1A

FIG 1B

FIG 1C

FIG 1D

FIG 1E

FIG 1F

FIG 1G

FIG 2A

FIG 2B